# EUROPEAN PATENT APPLICATION

(11) **EP 1 662 018 A2**
(43) Date of publication of application: **31.05.2006**
(21) Application number: 05255241.1
(22) Date of filing: 25.08.2005
(51) Int. Cl.: C23C 14/34

(54) **Carbon containing sputter target alloy compositions**

(30) Priority: 24.11.2004 US 995112
(71) Applicant: Heraeus, Inc., Chandler, AZ 85226 (US)
(72) Inventor: Ziani, Abdelouahab, Chandler, AZ 85226 (US); Lathrop, Michael, Big Bend, WI 53103-9579 (US); Dary, Francois C, Phoenix, AZ 85044 (US)
(74) Representative: Hill, Justin John

(57) **Abstract**

The invention provides a sputter target material. The sputter target material comprises an alloy system comprising Cr-C, Cr-M-C or Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te. A magnetic recording medium comprising a substrate and at least an underlayer comprising the sputter target material of the invention also is provided. A method of manufacturing a sputter target material further provided. The method can employ powder materials comprising a combination of elements can include a chromium alloy, a carbide or carbon containing master alloy.

## Description

### CARBON CONTAINING SPUTTER TARGET ALLOY COMPOSITIONS

### FIELD OF THE INVENTION

This invention relates generally to sputter targets and, more particularly, to a method of producing carbon containing chromium based alloy materials that promote favorable epitaxial growth of magnetic crystalline planes in cobalt alloy magnetic films.

### BACKGROUND OF THE INVENTION

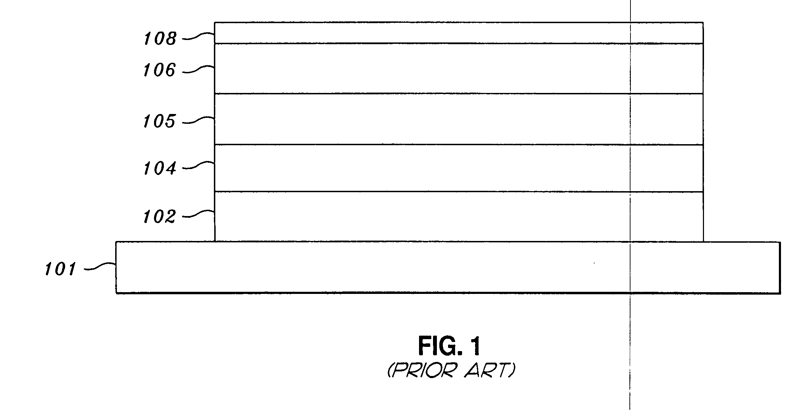

The process of sputtering is widely used in a variety of fields to provide thin film material deposition of a precisely controlled thickness with an atomically smooth surface, for example to coat semiconductors and/or to form films on surfaces of magnetic recording media. During the production of conventional magnetic recording media, layers of thin films are sequentially sputtered onto a substrate by multiple sputter targets, where each sputter target is comprised of a different material, resulting in the deposition of a thin film "stack." Figure 1 illustrates a typical thin film stack for conventional magnetic recording media. At the base of the stack is non-magnetic substrate 101, which is typically aluminum or glass. Seed layer 102, the first deposited layer, typically forces the shape and orientation of the grain structure of higher layers, and is commonly comprised of NiP or NiAl. Next, a non-magnetic underlayer 104, which often includes one to three discrete layers, is deposited, where the underlayer is typically a chromium-based alloy, such as CrMo, or CrTi. Interlayer 105, which includes one or two separate layers, is formed above underlayer 104, where interlayer 105 is cobalt-based and slightly magnetic. Overlayer 106, which is magnetic and may include two or three separate layers, is deposited on top of interlayer 105, and carbon lubricant layer 108 is formed over overlayer 106.

The amount of data that can be stored per unit area on a magnetic recording medium is inversely proportional to the size of the grain of the overlayer. Grain boundary segregation of minor addition elements also contributes to increased data storage potential. Grain size and uniform grain boundary segregation of the overlayer can be influenced by the properties of an earlier deposited thin film of the stack and particularly by the properties of an underlayer.

One technique for promoting desirable microstructures in a magnetic alloy thin film layer is through the use of underlayer alloys. Chromium containing underlayers exhibit a tendency to promote epitaxial growth of magnetic crystalline planes in cobalt alloy magnetic films. Chromium underlayers additionally promote fine grain structure, which reduces media noise in the magnetic film application. Underlayer alloys can be generally described as Cr-X-Y alloy systems. The X element represents large atom elements such as Mo, Ta or W that expand a chromium alloy lattice. The Y element represents smaller atom elements such as boron, B, which tends to segregate to grain boundaries and serves or acts as a grain growth inhibitor.

Sputter targets made from consolidated materials of powder blends containing graphite powder in elemental form are prone to particle generation occurring through spitting during the sputtering process. The use of graphite powder in preparing sputter target material also yields unfavorable carbon distributions throughout the target. Accordingly, conventional techniques for producing carbon containing chromium alloys detract from their use as sputter target material and temper any beneficial epitaxial growth properties of such alloys that can be achieved in cobalt alloy magnetic recording layers.

It is therefore considered highly desirable to provide carbon containing chromium based alloys sputter target material in to promote optimal epitaxial growth of preferred magnetic crystalline planes in cobalt alloy films of a magnetic recording medium. In particular, it is desirable to provide stoichiometrically favorable carbide compounds or carbon containing master alloys in order to achieve optimal distribution of carbon throughout a sputter target and sputtering into thin films with optimal epitaxial match for a cobalt alloy magnetic layer.

### SUMMARY OF THE INVENTION

The embodiments of the present invention intend to solve the foregoing problems by providing a powder metallurgy method for manufacturing sputter target material for sputtering an underlayer of a magnetic recording medium, where the sputter target is comprised of a carbon containing chromium alloy composition which effectuates favourable epitaxial growth for optimal match with a cobalt alloy thin film layer.

According to one aspect, the present invention provides a sputter target material. The sputter target material has an alloy system comprising Cr-C, Cr-M-C or Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, A1, Sc, Mn, Y, and Te.

According to another aspect, the invention provides a magnetic recording medium. The magnetic recording medium comprises a substrate and at least an underlayer. The underlayer has an alloy system comprising Cr-C, Cr-M-C, and Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te.

According to a further aspect of the invention, a method of manufacturing a sputter target material is provided. The method comprises: (a) selecting powder materials of elements, or a combination of elements thereof, for an alloy system comprising Cr-C, Cr-M-C or Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting ofTi, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te, and wherein the powder materials are selected to have at least a purity level, mesh size and particle morphology effective for a sputter target material; (b) combining the selected powder materials of elements, or combinations thereof, to produce an unconsolidated formulation for the alloy system, and (c) densifying the unconsolidated formulation to produce a sputter target material. Powder materials comprising a combination of elements can include a chromium alloy such as chromium carbide. Powder materials comprising a combination of elements also can include a carbide or carbon containing master alloy. Exemplary carbides or carbon containing master alloys can be Ti-C, V-C, Y-C, Zr-C, Nb-C, Mo-C, Hf-C, Ta-C, W-C, Li-C, Mg-C, Al-C, Sc-C, Mn-C, Y-C, and Te-C.

In the following description of exemplary embodiments, reference is made to the accompanying drawings that form a part thereof, and in which is shown by way of illustration a specific embodiment in which the invention may be practiced. It is to be understood that other embodiments may be utilized and changes may be made without departing from the scope of the present invention.

### BRIEF DESCRIPTION OF THE DRAWINGS

Referring now to the drawings in which like reference numbers represent corresponding parts throughout:
Figure 1 depicts a typical thin film stack for conventional magnetic recording media;
Figure 2 depicts a thin film stack according to one aspect of the present invention;
Figure 3 shows a back-scattered image mode of a scanning electron micrograph (SEM) through a particle section of a pre-alloyed combination of elements corresponding to Cr-14C atomic percent (at%).
Figure 4 shows a SEM micrograph illustrating the distribution of a carbide phase in a Cr-C alloy obtained by consolidation of Cr and Cr₂C powder blend, and
Figure 5 shows a SEM micrograph illustrating the distribution of a carbide phase in a Cr-Mo-C alloy obtained by consolidation of Cr, Mo and Mo₂C powder blend.

### DETAILED DESCRIPTION OF THE INVENTION

The present invention allows for increased data storage of a magnetic recording medium by manufacturing carbon containing chromium alloy sputter target material from raw materials of individual elements, carbides or from master alloys containing carbon in order to achieve optimal epitaxial growth in a sputtered underlayer and epitaxial match with a sputtered magnetic overlayer thin film.

Applying powder metallurgy methodology to the manufacturing of sputter target materials having alloy systems represented by the formula Cr-C, Cr-M-C or Cr-M₁-M₂-C confers versatility to the production of a wide range of carbon containing alloy systems. Manufacture of the sputter target materials of the invention employs powder formulations of individual elements, carbides or carbon containing master alloys containing elements belonging to groups II-A through VIIA and groups I-B through IV-B of the periodic table. The manufacturing method of the invention provides an efficient means for producing carbon containing alloys in which the distribution of carbon containing particles can be optimized through the selection of favorable stoichiometry of individual elements, carbides or master alloy additives as well as the particle size distribution of those additives. Another beneficial attribute of employing elemental powder materials, carbides or master alloys rather than pure metal, graphite or both reduces particle generation during sputter as a result of erosion and spitting.

According to one embodiment, the invention provides a sputter target material. The sputter target material includes an alloy system comprising Cr-C, Cr-M-C or Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te. The sputter target material can be manufactured by densifying a powder blend formulation of the alloy system as described further below. Densification processes can include, for example, procedures such as hot isostatic pressing (HIP); other high pressure, high temperature processes; cold powder press and sinter, and other pressureless methods as well as other procedures well known to those skilled in the powder metallurgy art.

Sputter target material of the invention ca n include, for example, any combination of atomic percentages of carbon, C, and of elements of groups II-A through VII-A and groups I-B through IV-B of the periodic table as set forth above. Sputter target material can have a carbon composition ranging from at least 0.5 and as much as 20 atomic percent. Other embodiments include a carbon composition within a sputter target material ranging from at least 1.0 and as much as 10 atomic percent. Further embodiments include carbon ranging from at least 1.5 and as much as 8 atomic percent. Exemplary embodiments of sputter target materials having the alloy system Cr-M-C, where carbon consists of 2-6 atomic percent include Cr-20M-6C, Cr-20M-2C, Cr-6M-4C, Cr-20M-4C and Cr-6M-2C, where numbers correspond to atomic percent of the referenced element within the alloy. All atomic percentages within the above exemplary ranges also can be employed in a sputter target material of the invention. Those skilled in the art will understand that selection and production of a sputter target material having a particular atomic percent of carbon within the above ranges can be performed using the methods of the invention described herein.

Sputter target materials of the invention also will include a composition of elements of groups II-A through VII-A and groups I-B through IV-B. Depending on the alloy system produced, these elements include M, which can be selected from the elements Ti, V, Y, Zr, Nb, Mo, Hf, Ta, and W, or M₁, which can be selected from the elements Ti, V, Zr, Nb, Mo, Hf, Ta, and W, and M₂, which can be selected from the elements Li, Mg, Al, Sc, Mn, Y, and Te. In some embodiments, such as when M or M₁ is Ti, the atomic percent can be at least 10 and as much as 50 atomic percent. Other exemplary embodiments of sputter target materials having the alloy system Cr-C, Cr-M-C or Cr-M₁-M₂-C include Cr-4C, Cr-15W-SC, Cr-20Mo-2Ti-2C and Cr-20Mo-2Ta-2C.

For the alloy system Cr-M-C, a sputter target material can have a composition of M ranging from at least 0.5 and as much as 20 atomic percent. Other embodiments include a composition of M within a sputter target material ranging from at least 1.0 and as much as 10 atomic percent. Further embodiments include M ranging from at least 1.5 and as much as 8 atomic percent. Exemplary embodiments of sputter target materials where M is Mo, the atomic percent of Mo consists of 6-20 atomic percent and include Cr-20M-6C, Cr-20M-2C, Cr-6M-4C, Cr-20M-4C and Cr-6M-2C, where numbers correspond to atomic percent of the referenced element within the alloy. As with the carbon percentages described above, sputter target materials having all atomic percentages of M within these exemplary ranges also can produced using the methods of the invention.

Sputter target materials for the alloy system Cr-M₁-M₂-C can have a composition of M₁ ranging from at least 0.5 and as much as 20 atomic percent. Other embodiments include a composition of M₁ within a sputter target material ranging from at least 1.0 and as much as 10 atomic percent. Additional embodiments include M₁ ranging from at least 1.5 and as much as 8 atomic percent. The alloy system can have a composition of M₂ ranging from at least 0.5 and as much as 10 atomic percent. Other embodiments include a composition of M₂ ranging from at least 1.0 and as much as 4.0 atomic percent. Further embodiments include M₂ ranging from at least 1.5 and as much as 3.5 atomic percent. Exemplary embodiments of sputter target materials where either M₁ or M2 is Mo, the atomic percent of Mo includes 6-20 atomic percent. As with the carbon percentages described above, sputter target materials having all atomic percentages of M₁ or M₂ as well as all possible combinations and permutations of these percentages within the above exemplary ranges can be produced using the methods of the invention.

Sputter target materials comprising an alloy system of the invention will have a chromium composition comprising the balance of the alloy to reach 100 atomic percent. For a Cr-C alloy system, the chromium composition will correspond to 100 atomic percent less the atomic percentage of C contained in the alloy system. Thus, Cr can range from 80 to 99.5 atomic percent in a sputter target material comprising a Cr-C alloy system. Sputter target material having an alloy system Cr-M-C will have a chromium composition corresponding to 100 atomic percent less the atomic percentages of the sum of M and C contained in the alloy system. In this alloy system, Cr can range from 60 to 99 atomic percent in a sputter target material. For example, an alloy system Cr-M-C consisting of Cr-6Mo-2C will have a chromium composition of 92 atomic percent. Similarly, sputter target material having an alloy system Cr-M₁-M₂-C will have a chromium composition corresponding to 100 atomic percent less the atomic percentages of the sum of M₁, M₂ and C contained in the alloy system. For example, Cr can range from 50 to 98.5 atomic percent in a sputter target material having a Cr-M₁-M₂-C alloy system of the invention. In particular instances, it can be beneficial to increase the amounts of C, M, M₁ or M₂ to higher atomic percentages than the ranges set forth above. In such instances, the chromium composition of the resultant sputter target material will be correspondingly decreased to make up the balance of the alloy system to 100 atomic percent.

Those skilled in the art will understand that a sputter target material can be produced having all possible permutations and combinations of elements Cr, M, M₁, M₂ and C for any of the allow systems Cr-C, Cr-M-C or Cr-M₁-M₂-C given the teachings and guidance provided herein. The choice of an alloy system, the atomic percentage of each element and which elements to use for M, M₁ or M₂ can be selected, for example, on the intended use of the sputter target material. All of the alloy systems described herein promote efficient epitaxial growth and matching for magnetic recording media. Moreover, the alloy system, elemental composition and/or atomic percentages of a selected alloy system of the invention can be varied to optimize epitaxial matching for use with different magnetic recording media, for example. Making and testing differing compositions of an alloy system the invention for optimization is well known to those skilled in the art.

According to another embodiment, the invention also provides a sputter target formulation. The sputter target formulation includes powder blend materials of elements, or a combination of elements thereof, for an alloy system comprising Cr-C, Cr-M-C or Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te, and wherein said powder materials are selected to have at least a purity level, mesh size and particle morphology effective for a sputter target material.

The sputter target formulations of the invention consist of powder blends of raw materials of elements used for the production of a sputter target material of the invention. The raw materials of elements are selected as described below and combined into an unconsolidated blend prior to consolidation by densification. Therefore, the formulations comprise unconsolidated powder blend materials of elements and atomic percentages corresponding to any of the alloy systems described previously for a sputter target material of the invention. The formulations also can include unconsolidated powder blend materials where one or more of such materials corresponds to a combination of elements of an alloy systems of the invention.

Similarly, two or more powder materials corresponding to combinations of elements also can be included in a sputter target formulation of the invention. Combinations of elements can include, for example, stoichiometrically favorable aggregates of two or more elements selected from Cr, M, M₁, M₂ or C.

Constituents of the sputter target formulations corresponding to powdered materials of elements include, for example, Cr, C, M where M is selected from Ti, V, Y, Zr, Nb, Mo, Hf, Ta, and W, M₁ where M₁ is selected from Ti, V, Zr, Nb, Mo, Hf, Ta, and W, and M₂ where M₂ is selected from Li, Mg, Al, Sc, Mn, Y, and Te. The constituents of a formulation can be in the form of raw materials corresponding to an individual element. Alternatively, constituents can be present in the form of combinations of the above elements. A combination of elements can be any binary or higher order compound and includes, for example, an alloy, a master alloy or a carbide. Specific examples of powder materials of a combination of elements include a chromium alloy or a carbon containing master alloy. Exemplary carbides include Cr-C, Ti-C, V-C, Y-C, Zr-C, Nb-C, Mo-C, Hf-C, Ta-C, W-C, Li-C, Mg-C, Al-C, Sc-C, Mn-C, Y-C or Te-C, and having a stoichiometry well known in the art.

Sputter target formulations can be blended to contain a wide variety of constituent powder materials of elements or combinations thereof. For example, powder materials for each individual element are selected and combined into an unconsolidated formulation in specified atomic percentages that correspond to one or more of the alloy systems described previously. Alternatively, a sputter target formulation can be blended from one or more individual elements and from one or more materials corresponding to a combination of elements such as a carbide, an alloy or a master alloy. The alloy or master alloy can additionally contain carbon. Further, a sputter target formulation also can be blended from two or more materials corresponding to a combination of elements that specify an alloy system of the invention. Therefore, the powder materials of elements corresponding to constituents of a sputter target formulation can vary so long as the final formulation contains constituent elements and atomic percentages that specify an alloy system of the invention. The processes of selection and combining into a formulation can be performed as described below or according to methods well known in the material sciences. The resultant sputter target formulation can be densified to produce a sputter target.

In a further embodiment, the invention provides a magnetic recording medium. The magnetic recording medium comprises a substrate and at least an underlayer. The underlayer of the magnetic recording medium includes an alloy system comprising Cr-C, Cr-M-C, and Cr-M₁₋M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te.

A sputter target material produced from the powder metallurgy methods of the invention can be used to sputter onto a substrate to manufacture a thin film layer comprised of the alloy system for the chosen sputter target. An exemplary thin film layer that can be produced using the sputter targets of the invention is an underlayer of a magnetic recording medium. Underlayers comprised of an alloy system of the invention represented by the formula Cr-C, Cr-M-C or Cr-M₁-M₂-C promote favorable epitaxial growth of magnetic crystalline planes in cobalt alloy overlayer thin films. Therefore, sputter targets can be produced from sputter target material of the invention and used to sputter a variety of underlayer thin films for the production of different magnetic recording media useful in a wide range of applications.

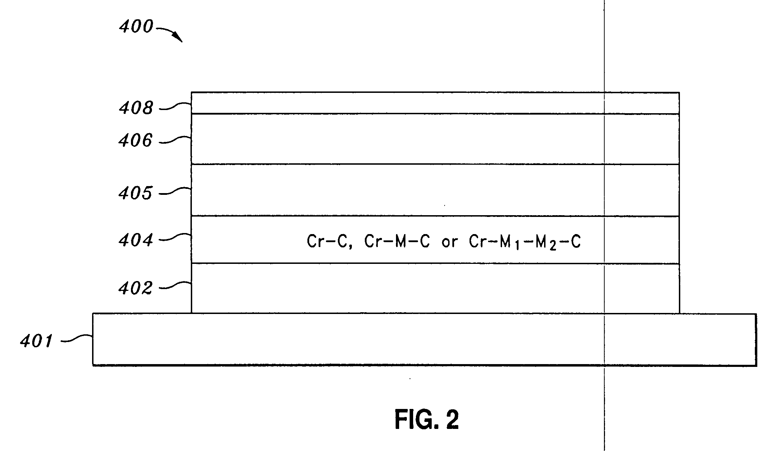

Figure 2 depicts a thin film stack of a magnetic recording medium according to one embodiment of the present invention. Briefly, the magnetic recording medium includes a substrate, and at least one underlayer formed over the substrate, where the underlayer includes an alloy system comprising Cr-C, Cr-M-C, and Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te. The magnetic recording medium also can include, for example, at least one interlayer formed over the underlayer. An exemplary interlayer can consist of a Co-based alloy. The magnetic recording medium can additionally include, for example, at least one overlayer formed over the interlayer. The overlayer similarly can consist of a Co-based alloy.

In this regard, an exemplary thin film stack of a magnetic recording medium 400 includes substrate 401, which is generally aluminum or glass. Seed layer 402 can be formed over substrate 401, where seed layer 402 molds the shape and orientation of the grain structure of subsequently deposited thin film layers. Generally, seed layer 402 can consist of NiP or NiAl. In an alternate arrangement of the present invention, seed layer 402 can be omitted.

Underlayer 404 is formed over seed layer 402, or over substrate 401 if seed layer 402 is omitted. Although underlayer 404 is depicted as one layer, in alternate aspects of the present invention underlayer 404 can consist of from one to three or more layers. Underlayer 404 is comprised of an alloy system of the invention having the formula Cr-C, Cr-M-C or Cr-M₁-M₂-C, where C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te. An underlayer of a magnetic recording medium of the invention also can contain additional elements or chemical compounds. For example, an underlayer comprising an alloy system of the invention can included oxide or other compounds facilitating favorable grain structure of subsequently deposited thin film layers.

Interlayer 405 can be formed over underlayer 404. Interlayer 405 is illustrated as one layer, however in an additional arrangement, interlayer 405 can consist of from one to three or more layers. Interlayer 405 can be comprised of a cobalt-based alloy and also can further include additional elements or compounds such as an oxide which facilitates favorable grain structure. Interlayer 406 can be slightly magnetic.

Overlayer 406 can be formed over interlayer 405. In Figure 2, overlayer 406 is shown as one layer. In a further additional aspect of the present invention, overlayer 405 can consist of from one to three or more layers. Overlayer 406 similarly can be comprised of a cobalt-based alloy and also can include additional elements or compounds such as an oxide which facilitate favorable grain structure.

Carbon lubricant layer 408 can be formed over overlayer 406, where the lubricant layer includes C or a carbon-based alloy. Carbon lubricant layer 408 protects overlayer 406 from damage caused by physical contact between a read-write head (not depicted) and overlayer 408 itself. In an alternate aspect of the present invention, carbon lubricant layer 408 can be omitted.

In a further embodiment, the invention provides a method of manufacturing a sputter target material having alloy systems represented by the formula Cr-C, Cr-M-C or Cr-M₁-M₂-C. As described previously, powder materials of constituent elements, or combinations of constituent elements, corresponding to these alloy systems can be combined to produce unconsolidated formulations where C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te. The powder materials of elements, or combinations thereof, are selected to have at least a purity level, mesh size and particle morphology effective for a sputter target material. The sputter target formulation can be consolidated by, for example, densification to produce a sputter target material, which can be subsequently processed into a sputter target.

The method of manufacturing a sputter target material of the invention includes selection of powder materials of elements, or combinations of elements thereof, having desired physical and/or chemical properties. One advantage of the method of the invention is that stoichiometrically favorable aggregates of constituent elements can be selected and employed to manufacture all combinations of elements and atomic percentages of the alloy systems of the invention represented by the formula Cr-C, Cr-M-C or Cr-M₁-M₂-C.

Briefly, powder materials are selected for a desired alloy system. For example, Cr and C are selected for a Cr-C alloy system. Powder material of elements Cr, C and M are selected for a Cr-M-C alloy system where M corresponds to any one of Ti, V, Y, Zr, Nb, Mo, Hf, Ta, and W. Similarly, Cr, C, M₁ and M₂ are selected for a Cr-M₁-M₂-C alloy system where M₁ corresponds to any one of Ti, V, Zr, Nb, Mo, Hf, Ta or W and M₂ corresponds to any one of Li, Mg, Al, Sc, Mn, Y, and Te. Powder material of individual elements can be selected or combinations of elements can be selected that correspond to two or more elements of the desired alloy system. For example, the carbides Mo-C and Cr-C can be selected in stoichiometrically favorable combinations as powder materials for manufacturing the alloy system Cr-M-C where M is Mo. Selection of powder materials of elements having desirable or predetermined physical and/or chemical properties is well known to those skilled in the art of material science.

Selection of powder materials of elements having desired physical and/or chemical properties also includes selection of a powder material having a purity level effective for a sputter target material. An effective purity level will be chosen based on the intended application of the sputter target. Certain thin film applications require high purity levels to be effective as a thin film in a magnetic recording medium. High purity levels include powders of raw materials of elements, or combinations of elements such as the carbides or carbon containing alloys described previously, having a purity level of at least about 99.94 %. An example of a sputtered thin film underlayer having benefited by a high purity level is Cr-4C where the purity levels of the powder materials of elements correspond to 99.98 %Cr and 99.50 % Cr₃C₂. Other thin film applications can use lower purity levels of powder materials including, for example, purity levels of at least about 99.90% and as much as 99.93%. Still other sputtered thin film underlayer application can have lower purity levels of powder materials while still being effective and include, for example, purity levels of at least about 99.85 or lower % and as much as 99.89%. Specific examples of the underlayer applications requiring the latter two ranges of purity levels include Cr-15Mo-4C and Cr-20Mo-6C, respectively, where the purity levels of the powder materials of elements correspond to 99.98 % Cr, 99.90 % Mo and 99.5 % Mo₂C.

Selection of powder materials of elements for an alloy system of the invention can additionally include selection of a mesh size effective for a sputter target material. An effective mesh size will be chosen based on, for example, the amount of powder in the formulation mixture, which corresponds to the atomic percentage of the alloy system element within the formulation. An effective mesh size also can be chosen based on, or including, other physical and/or chemical properties such as the atomic size of the element or elements of the end product alloy system.

Mesh size also can be chosen based on other factors and include, for example, consideration of atomic percentages with respect to the generation of homogeneous powder formulations. For example, smaller atomic percentages of a powder material require greater care in mixing with other powder materials of a formulation to produce a homogeneous or substantially homogeneous formulation. Finer mesh sizes for M, M₁, M₂ and/or C can be selected for these constituents of an alloy system of the invention to achieve a higher uniformity and/or more optimal distribution throughout a sputter target material. Mesh size can be adjusted to match a particular mixing procedure by selecting a different element within a like group of elements for the alloy systems of the invention in order to achieve homogeneity of the powder formulation. Another factor includes the activation of phase changes beneficial to the alloy system. For example, smaller mesh sizes, such as those produced by carbon, can result in desirable activation of phase changes and therefore selected as an effective mesh size for a particular alloy system of the invention. Exemplary mesh sizes for powder materials of elements for the alloy system Cr-M-C, where M corresponds to Mo are 100 mesh for Cr, 325 mesh for Mo and 325 mesh for Carbide.

Selection of powder materials of elements for an alloy system of the invention can further include selection of a particle morphology effective for a sputter target material. The particle shape of powdered elements, carbides or carbon containing master alloys effective for a sputter target can be chosen based on the desired densification process to be used in producing a sputter target. For example, particle size of powder materials can be on the coarse mesh size where a hot isostatic pressing (HIP) method will be employed for densification. Coarser mesh sizes include, for example, 100 mesh. Alternatively, where pressureless densification methods are to be used, selection of finer particle sizes are beneficial for complete sintering and achievement of up to 100% density for a alloy system of the invention. Lower pressure and temperature methods of densification include, for example, cold powder press and sinter. Exemplary particle sizes applicable for these methods of densification include, for example, 325 mesh.

The above powder materials of elements, including combinations thereof such as carbides or carbon containing alloys, can be produced by any of various chemical and physical methods well known in the art of material science. The above powder materials of elements, including combinations thereof such as carbides or carbon containing alloys, also can be manufactured by any of various processes well known in the art of material sciences. A particularly useful manufacturing process includes atomization methods which can produce powder materials exhibiting beneficial characteristics such as uniform chemical homogeneity and spheroidal particle shape for improved densification when high pressure, high temperature processes are employed.

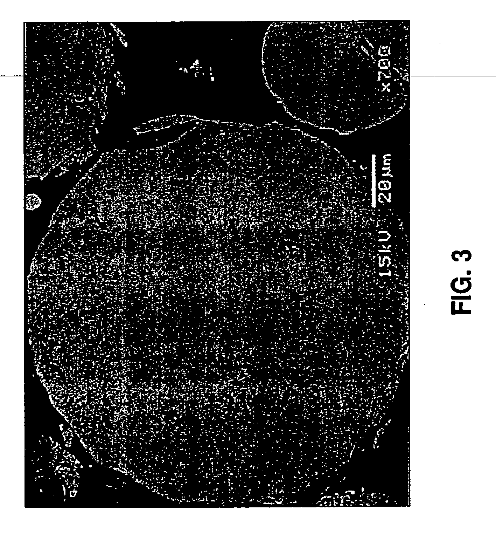

Another alternative for making carbon containing chromium alloys is to use a pre-alloyed powder of chromium and carbon. This raw material can be prepared, for example, by melting and atomizing a Cr-C master alloy. In the following example, 99.98 % Cr melt stock was melted by vacuum induction along with 99.9 % graphite flake. The desired composition for the pre-alloyed material was the combination of elements Cr-C where C was present at 14 atomic percent, or Cr-14C. The molten alloy was then gas atomized with a high pressure argon jet into fine droplets which subsequently solidified into spherical particles. The typical microstructure of the as-solidified powder is shown in Figure 3, which is a back-scattered image mode of a scanning electron micrograph (SEM). This micrograph reveals the microstructure through a particle section of the powder.

The microstructure of the Cr-14C combination of elements consists of uniformly distributed 1-2 µm carbide particles (arrows) within a supersaturated chromium matrix. The chemical composition for this powder is listed in the following table:

| **Ca ppm** | **Fe ppm** | **Mn ppm** | **Ni ppm** | **Si ppm** | **V ppm** | **O ppm** | **N ppm** | **S ppm** | **C* at. %** |
|---|---|---|---|---|---|---|---|---|---|
| 64 | 186 | 7 | 7 | 81 | 46 | 32 | 9 | 87 | 13.82 |

Powder materials of elements, or combinations thereof, that are constituents of an alloy system of the invention are combined into a sputter target formulation following selection of powder elements, or combinations thereof, having effective purity levels, mesh size and particle morphology. The powders are combined in selected amounts to achieve atomic percentages of an alloy system comprising Cr-C, Cr-M-C or Cr-M₁-M₂-C, where C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te. Combining powder materials of elements, or combinations thereof, includes mixing or blending the constituent powder materials to create a homogeneous or substantially homogenous powder formulation. As with the production of the powder material constituents of an alloy system, the alloy formulations also can be generated using any of various chemical and physical methods well known in the art of material science including, for example, manufactured by atomization methods to achieve favorable homogeneity and morphology characteristics of the alloy formulation. Other methods well known to those skilled in the art of material science also can be employed to combine powder materials and/or to achieve homogeneous mixtures.

Following selecting and combining powder materials of elements, or a combination of elements thereof, so as to have at least a purity level, mesh size and particle morphology effective for a sputter target material comprising an alloy system Cr-C, Cr-M-C or Cr-M₁-M₂-C as described above, a powder formulation is produced containing the elements and atomic percentages of the selected alloy system. This powder formulation can be stored for later use following procedures well known in the art of material science or it can be immediately used for the production of a sputter target material comprised of the selected alloy system.

Sputter target material can be manufactured by densification methods in which a mass of powder is formed into a shape or "can," then consolidated to form inter-particle metallurgical bonds. For the specific example of densification using HIP, elemental materials are mixed to produce a homogeneous blend, the powders are encapsulated in a metal container, and the container is out-gassed to avoid contamination of the materials by any residual gas. A hot isostatic pressing occurs on the container, in which heat and isostatic pressure are applied on the vessel to consolidate the powder, turning loose powder into a densified matter known as a "HIP'ed can." The HIP'ed can then can be sliced to create multiple sputter target blanks, and the target blanks can be machined into an appropriate shape, which may be round, rectangular, or polygonal. Once shaping is complete, the sputter targets can be laid flat and polished with a grinder or abraded.

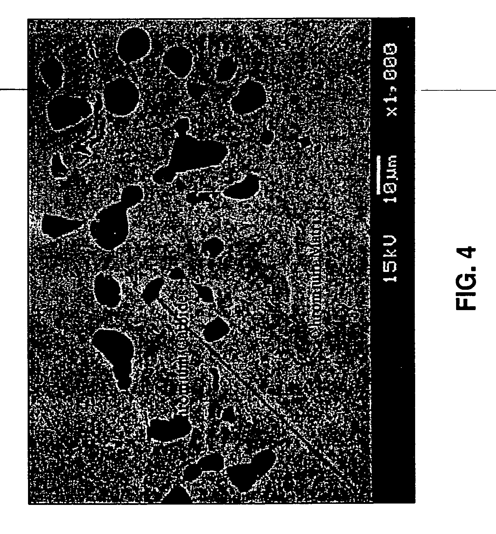

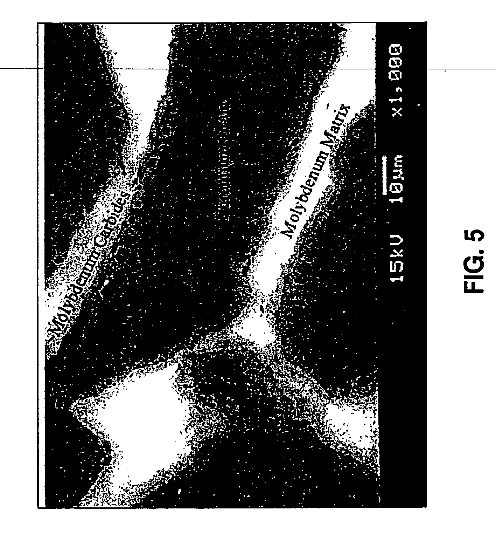

Figures 4 illustrates a typical microstructure of a sputter target material with an alloy system having the formula Cr-C. Figure 5 illustrates a typical microstructure of a sputter target material with an alloy system having the formula Cr-M-C where M is Mo. For both the Cr-C and the Cr-M-C alloy systems, C was introduced into a sputter target formulation using Cr or Mo carbides, respectively. In particular, Figure 4 illustrates a scanning electron micrograph (SEM) showing the distribution of the carbide phase in a Cr-C alloy manufactured by consolidation of Cr and Cr₂C powder materials. Figure 5 illustrates a SEM showing the distribution of the carbide phase in a Cr-M-C alloy, where M consists of Mo, manufactured by consolidation of Cr, Mo and MO₂C powder materials.

Although the invention has been described with reference to the disclosed embodiments, those skilled in the art will readily appreciate that the specific examples and studies detailed above are only illustrative of the invention. It should be understood that various modifications can be made without departing from the spirit of the invention. Accordingly, the invention is limited only by the following claims.

## Claims

1. A sputter target material having an alloy system comprising Cr-C, Cr-M-C or Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te.

2. The sputter target material of claim 1, wherein C further comprises at least 1.0 and as much as 10 atomic percent.

3. The sputter target material of claim 1, wherein C further comprises at least 1.5 and as much as 8 atomic percent.

4. The sputter target material of claim 1, wherein M comprises Mo.

5. The sputter target material of claim 4, wherein said alloy system is selected from the group consisting of Cr-20Mo-6C, Cr-20Mo-2C, Cr-6Mo-4C, Cr-20Mo-4C and Cr-6Mo-2C.

6. The sputter target material of claim 1, wherein said alloy system is selected from the group consisting of Cr-4C, Cr-15W-SC, Cr-20Mo-2Ti-2C and Cr-20Mo-2Ta-2C.

7. A magnetic recording medium comprising a substrate and at least an underlayer, said underlayer having an alloy system comprising Cr-C, Cr-M-C, and Cr-M₁-M₂-C, wherein C comprises at least 0.5 and as much as 20 atomic percent; M comprises at least 0.5 and as much as 20 atomic percent and is an element selected from the group consisting of Ti, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te.

8. The magnetic recording medium of claim 7, wherein C further comprises at least 1.0 and as much as 10 atomic percent.

9. The magnetic recording medium of claim 7, wherein C further comprises at least 1.5 and as much as 8 atomic percent.

10. The magnetic recording medium of claim 7, wherein M comprises Mo.

11. The magnetic recording medium of claim 10, wherein said alloy system is selected from the group consisting of Cr-20Mo-6C, Cr-20Mo-2C, Cr-6Mo-4C, Cr-20Mo-4C and Cr-6Mo-2C.

12. The sputter target material of claim 7, wherein said alloy system is selected from the group consisting of Cr-4C, Cr-15W-5C, Cr-20Mo-2Ti-2C and Cr-20Mo-2Ta-2C.

13. A method of manufacturing a sputter target material, comprising:
(a) selecting powder materials of elements, or a combination of elements thereof, for an alloy system comprising Cr-C, Cr-M-C or Cr-M₁-M₂-C,
wherein C comprises at least 0.5 and as much as 20 atomic percent; M comprises at least 0.5 and as much as 20 atomic percent and is an element selected from the group consisting ofTi, V, Y, Zr, Nb, Mo, Hf, Ta, and W; M₁ comprises at least 0.5 and as much as 20 atomic percent and is an element selected from the group consisting of Ti, V, Zr, Nb, Mo, Hf, Ta, and W, and M₂ comprises at least 0.5 and as much as 10 atomic percent and is an element selected from the group consisting of Li, Mg, Al, Sc, Mn, Y, and Te, and
wherein said powder materials are selected to have at least a purity level, mesh size and particle morphology effective for a sputter target material, and
(b) combining said selected powder materials of elements, or combinations thereof, to produce an unconsolidated formulation for said alloy system, and
(c) densifying said unconsolidated formulation to produce a sputter target material.

14. The method of claim 13, wherein C further comprises at least 1.0 and as much as 10 atomic percent.

15. The method of claim 13, wherein C further comprises at least 1.5 and as much as 8 atomic percent.

16. The method of claim 13, wherein M comprises Mo.

17. The method of claim 16, wherein said alloy system is selected from the group consisting of Cr-20Mo-6C, Cr-20Mo-2C, Cr-6Mo-4C, Cr-20Mo-4C and Cr-6Mo-2C.

18. The method of claim 13, wherein said alloy system is selected from the group consisting of Cr-4C, Cr-15W-5C, Cr-20Mo-2Ti-2C and Cr-20Mo-2Ta-2C.

19. The method of claim 13, wherein said combination of elements comprises a chromium alloy.

20. The method of claim 19, wherein said chromium alloy comprises chromium carbide.

21. The method of claim 13, wherein said combination of elements comprises a carbide or carbon containing master alloy.

22. The method of claim 13, wherein said carbide or carbon containing master alloy is selected from the group consisting of Ti-C, V-C, Y-C, Zr-C, Nb-C, Mo-C, Hf-C, Ta-C, and W-C, Li-C, Mg-C, Al-C, Sc-C, Mn-C, Y-C, and Te-C.
